# EUROPÄISCHE PATENTANMELDUNG

(11) **EP 3 082 233 A1**
(43) Veröffentlichungstag der Anmeldung: **19.10.2016**
(21) Anmeldenummer: 15163516.6
(22) Anmeldetag: 14.04.2015
(51) Int. Cl.: H02K 11/00, G01R 31/34, G01R 31/12

(54) **ELEKTRISCHE MASCHINE UND VERFAHREN ZUM DETEKTIEREN VON TEILENTLADUNGEN IN DER ELEKTRISCHEN MASCHINE**

(71) Anmelder: Siemens Aktiengesellschaft, 80333 München (DE)
(72) Erfinder: Staubach, Christian, Dr., 45768 Marl (DE); Lang, Steffen, Dr., 91352 Hallerndorf (DE); Pohlmann, Friedhelm, Dr., 45355 Essen (DE); Schmidt, Guido, Dr., 42799 Leichlingen (DE); Staubach, Axel, 46282 Dorsten (DE)

(57) **Zusammenfassung**

Die Erfindung betrifft eine elektrische Maschine mit mindestens einem ein photoelektrisches Material aufweisenden Sensor (1), der derart angeordnet ist, dass eine Elektroisolation der elektrischen Maschine (9) in dem Sichtfeld des Sensors (1) liegt, und der derart eingerichtet ist, dass eine elektrische Größe des Sensors (1) auslesbar ist, und einer Auswerteeinheit, die derart eingerichtet ist, dass sie die elektrische Größe auslesen kann und mit ihr aus der elektrischen Größe auf das Vorhandensein einer Teilentladung in der Elektroisolation rückschließbar ist.

## Beschreibung

Elektrische Maschinen, wie Generatoren oder Motoren, weisen einen Ständer und einen Läufer auf. Der Ständer weist dabei eine Mehrzahl an Ständerwicklungen elektrischer Leiter und der Läufer weist zur Erzeugung eines Magnetfelds entweder einen Permanentmagneten oder eine Läuferwicklung elektrischer Leiter auf. Eine Elektroisolation ummantelt die elektrischen Leiter, um sie gegen benachbart angeordnete Windungen der Wicklungen, gegen die Umgebung und/oder gegen ein Blechpaket des Ständers elektrisch zu isolieren.

Fehlstellen in der Elektroisolation können im Betrieb der elektrischen Maschine zu Teilentladungen führen, die die Elektroisolation zersetzen. Dies kann im Extremfall zu einer vollständigen Zerstörung der Isolation führen, wodurch elektrische Durchschläge zwischen dem elektrischen Leiter und dem Blechpaket oder zwischen benachbarten Windungen der Wicklung erfolgen können.

Herkömmlich werden Teilentladungen detektiert, indem parallel an den zu untersuchenden elektrischen Leiter ein Koppelkondensator angeschlossen wird. Im Fall des Auftretens einer Teilentladung fließt ein impulsförmiger Ausgleichsstrom in einem den Koppelkondensator aufweisenden Messkreis, wobei der Ausgleichsstrom mittels eines Ankopplungsvierpols gemessen wird. Dies ermöglicht jedoch nur eine integrale Messung des gesamten elektrischen Leiters mit nur einer begrenzten Möglichkeit der Bestimmung des Orts der Teilentladung. Ebenso ist eine akustische Laufzeitmessung möglich. Hier kann jedoch eine Überlagerung mit Geräuschen der elektrischen Maschine erfolgen, was die Messgenauigkeit verringert. Es kann auch eine chemische Analyse von Isolierölen der elektrischen Maschine durchgeführt werden. Jedoch handelt es sich hier ebenfalls um eine integrale Messtechnik.

Aufgabe der Erfindung ist es, eine elektrische Maschine, bei der es möglich ist Teilentladungen zu detektieren, und ein Verfahren zum Detektieren von Teilentladungen in der elektrischen Maschine zu schaffen, bei denen das Vorhandensein einer Teilentladung mit einer hohen Messgenauigkeit und ortsaufgelöst erfolgt.

Die erfindungsgemäße elektrische Maschine weist mindestens einen ein photoelektrisches Material aufweisenden Sensor, der derart angeordnet ist, dass eine Elektroisolation der elektrischen Maschine in dem Sichtfeld des Sensors liegt, und der derart eingerichtet ist, dass eine elektrische Größe des Sensors auslesbar ist, und eine Auswerteeinheit auf, die derart eingerichtet ist, dass sie die elektrische Größe auslesen kann und mit ihr aus der elektrischen Größe auf das Vorhandensein einer Teilentladung in der Elektroisolation rückschließbar ist.

Das erfindungsgemäße Verfahren zum Detektieren von Teilentladungen in einer Elektroisolation einer elektrischen Maschine weist die Schritte auf: Anordnen mindestens eines Sensors mit einem photoelektrischen Material an der elektrischen Maschine derart, dass eine Elektroisolation der elektrischen Maschine in dem Sichtfeld des Sensors liegt; Messen einer elektrischen Größe des Sensors; Rückschließen aus der gemessenen elektrischen Größe auf das Vorhandensein einer Teilentladung in der Elektroisolation.

Das photoelektrische Material weist einen äußeren photoelektrischen Effekt, bei dem unter Einstrahlung von UV Strahlung Elektronen aus einer Oberfläche herausgelöst werden und/oder einen inneren photoelektrischen Effekt auf, bei dem in einem Halbleiter Elektronen-Loch-Paare erzeugt werden. Als elektrische Größe messbar sind ein elektrischer Widerstand, eine elektrische Spannung und/oder eine Stromstärke. Umgebungslicht löst in dem photoelektrischen Material keinen photoelektrischen Effekt aus. Damit hat das Umgebungslicht keinen Einfluss auf die gemessene elektrische Größe, wodurch mit dem Sensor das Vorhandensein einer Teilentladung mit einer hohen Genauigkeit bestimmbar ist. Zudem werden nur Teilentladungen detektiert, die sich in dem Sichtfeld des Sensors befinden, so dass die Bestimmung der Teilentladungen ortsaufgelöst erfolgen kann.

Der Sensor weist bevorzugt eine Blende auf, durch die das Sichtfeld auf den Sensor abgebildet wird. Dadurch lässt sich das Sichtfeld des Sensors einengen und somit vorteilhaft die Ortsauflösung des Sensors erhöhen.

Es ist bevorzugt, dass der Sensor eine Trägerplatte aufweist, auf die das photoelektrische Material aufgebracht ist, und die Blende einen lichtundurchlässigen Schirm aufweist, der an der Trägerplatte fest angebracht ist. Dadurch ergibt sich vorteilhaft eine kompakte und platzsparende Bauweise für den Sensor mit der Blende.

Bevorzugtermaßen weist der Schirm einen Ring auf, dessen eine Stirnseite an der Trägerplatte fest angebracht ist und dessen Ringöffnung sich in Richtung von der Trägerplatte weg verjüngt. Dadurch ist eine senkrechte Einstrahlung von Licht ermöglicht und eine seitliche Einstrahlung unterbunden. Alternativ ist der Schirm derart geformt, dass er das photoelektrische Material gegen eine senkrechte Einstrahlung abdeckt und eine seitliche Einstrahlung ermöglicht.

Bevorzugt ist eine Mehrzahl an den Sensoren vorgesehen, die derart angeordnet sind, dass deren Sichtfelder teilweise überlappen, so dass aus den ausgegebenen elektrischen Größen auf den Ort der Teilentladung zurückgeschlossen werden kann. Dadurch können Teilentladungen in einem großen Bereich der elektrischen Maschine detektiert werden und der Ort der auftretenden Teilentladungen mit einer hohen Genauigkeit bestimmt werden.

Es ist bevorzugt, dass die elektrische Maschine einen Wickelkopf aufweist und der mindestens eine Sensor derart angeordnet ist, dass mit ihm auf das Vorhandensein von Teilentladungen im Bereich des Wickelkopfes rückschließbar ist. Der Wickelkopf neigt im Betrieb der elektrischen Maschine dazu zu schwingen. Durch die Schwingungen können sich Hohlräume in der Elektroisolation des Wickelkopfes bilden. Die Hohlräume begünstigen die Bildung von Teilentladungen. Durch das Anordnen des mindestens einen Sensors im Bereich des Wickelkopfes wird vorteilhaft ein besonders anfälliger Bereich für die Bildung von Teilentladungen überwacht.

Die Elektroisolation umhüllt bevorzugt elektrische Leiter des Wickelkopfes und mindestens einer der Sensoren ist auf die Außenseite der Elektroisolation des Wickelkopfes aufgebracht. Dies stellt eine besonders platzsparende Anordnung für den Sensor dar und zudem ist an der Außenseite der Elektroisolation der Sensor unbeeinträchtigt von elektrischen und magnetischen Feldern der elektrischen Maschine.

Die elektrische Maschine weist bevorzugt eine Stützkonsole auf, die den Wickelkopf abstützt, und mindestens einer der Sensoren ist in der Stützkonsole angebracht. Dies stellt ebenfalls eine platzsparende Anordnung für die Sensoren dar.

Es ist bevorzugt, dass mindestens einer der Sensoren eingerichtet ist Strahlung, die in Radialrichtung der elektrischen Maschine gerichtet ist, zu erfassen und mindestens einer der Sensoren eingerichtet ist, Strahlung, die in Umfangsrichtung der elektrischen Maschine gerichtet ist, zu erfassen. Es ist bevorzugt, dass das photoelektrische Material ein Metalloxid aufweist, das in einer Trägermatrix eingebettet ist. Das Metalloxid ist bevorzugt Zinkoxid und/oder Zinnoxid. Die Trägermatrix ist bevorzugt ein glasverstärkter Kunststoff und/oder Polytetrafluorethylen (PTFE). Bevorzugt weist die Trägermatrix ein Elastomer auf. Das Elastomer ist bevorzugt eine raumtemperaturhärtende Polyesterimidmatrix. Dadurch wird vorteilhaft erreicht, dass sich das photoelektrische Material auch auf gekrümmte Oberflächen aufbringen lässt.

Es ist bevorzugt, dass eine Mehrzahl an Sensoren derart angeordnet wird, dass deren Sichtfelder teilweise überlappen, und wobei aus den gemessenen Größen auf den Ort der Teilentladung zurückgeschlossen wird. Erkennen mehrere der Sensoren das Vorhandensein einer Teilentladung, so befindet sich die Teilentladung im Überlappbereich der Sichtfelder der mehreren Sensoren. Erkennt nur eine der Sensoren das Vorhandensein einer Teilentladung, so befindet sich die Teilentladung in einem Bereich des Sichtfeldes, der nicht mit anderen Sichtfeldern überlappt.

Es ist bevorzugt, dass zum Rückschließen auf das Vorhandensein einer Teilentladung ein Vergleich der elektrischen Größe im Betrieb der elektrischen Maschine und der elektrischen Größe im Stillstand der elektrischen Maschine durchgeführt wird. Die elektrische Größe des photoelektrischen Materials hängt insbesondere ab von der Art und Konzentration des Metalloxids in dem Sensor. Tritt im Betrieb der elektrischen Maschine eine Teilentladung auf, so ergibt sich insbesondere eine Änderung der elektrischen Leitfähigkeit des photoelektrischen Materials. Diese Änderung hängt ab von der Intensität der Teilentladung und der Entfernung des Sensors von der Teilentladung. Die Änderung der elektrischen Leitfähigkeit kann sich über mehrere Dekaden erstrecken. Dadurch ist eine hohe Messgenauigkeit bei der Detektion von Teilentladungen möglich.

Im Folgenden wird anhand der beigefügten schematischen Zeichnungen die Erfindung naher erläutert. Es zeigen:
- Figur 1: einen Sensor,
- Figur 2: einen Sensor mit einem ersten Schirm,
- Figur 3: einen Sensor mit einem zweiten Schirm und
- Figur 4: einen Querschnitt durch eine elektrische Maschine im Bereich ihres Wickelkopfes.

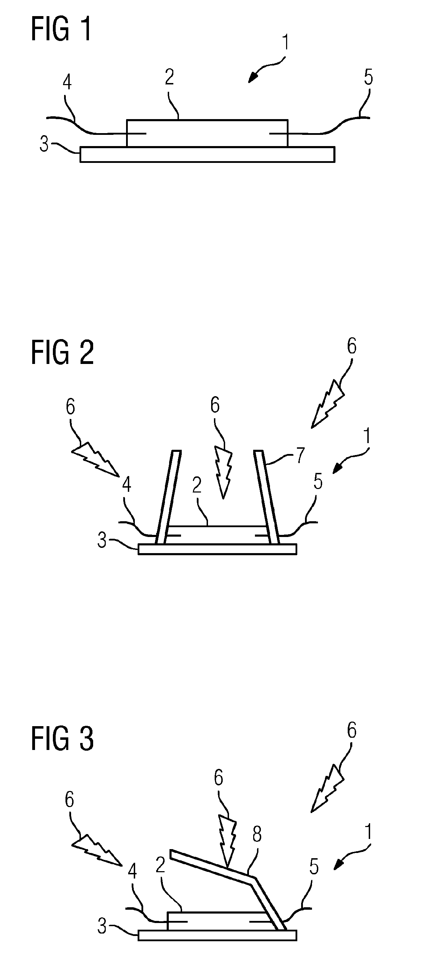

Wie es aus Figuren 1 bis 3 ersichtlich ist, weist ein Sensor 1 eine Trägerplatte 3 auf, auf die eine Schicht 2 aufgebracht ist, wobei die Schicht 2 ein photoelektrisches Material aufweist. Der Sensor 1 weist einen ersten Leitungsdraht 4 und einen zweiten Leitungsdraht 5 auf, die an gegenüberliegenden schmalen Seiten der Schicht 2 angebracht sind, so dass eine elektrische Größe der Schicht 2 messbar ist. Bei der elektrischen Größe kann es sich um die Leitfähigkeit, die elektrische Spannung und/oder um die Stromstärke handeln. Die Leitungsdrähte 4, 5 sind an eine Auswerteeinheit angeschlossen, die eingerichtet ist, die elektrische Größe auszulesen und aus der elektrischen Größe auf das Vorhandensein einer Teilentladung zurückzuschließen.

Die Schicht 2 weist das photoelektrische Material auf, welches in eine Trägermatrix eingebracht ist. Das photoelektrische Material kann ein Metalloxid sein. Die Schicht 2 mit dem photoelektrischen Material und der Trägermatrix kann beispielweise auf die Trägerplatte 3 gerakelt oder gepinselt sein. Für die Trägermatrix kann ein Elastomer verwendet werden, wodurch der Sensor 1 auch auf gekrümmte Oberflächen aufgebracht werden kann. In dem Fall, dass der Sensor 1 auf gekrümmte Oberflächen aufgebracht wird, könnte die Trägerplatte 3 ebenfalls aus einem elastischen Material hergestellt sein.

Der Sensor 1 gemäß Figur 2 weist einen ersten Schirm 7 auf, der undurchlässig für UV-Strahlung ist. Der erste Schirm 7 stellt eine Blende dar, die das Sichtfeld des Sensors 1 einengt. Der erste Schirm 7 hat die Form eines Ringes, dessen eine Stirnseite fest an der Trägerplatte 3 angebracht ist. Die Schicht 2 befindet sich im Inneren dieses Ringes. Der Öffnungsdurchmesser des Ringes verjüngt sich in Richtung weg von der Trägerplatte 3, so dass der Ring die Form eines Kegelstumpfmantels hat. Wie es aus Figur 2 ersichtlich ist, bewirkt diese Anordnung, dass nur Strahlung 6, die senkrecht auf den Sensor 1 auftritt, die Schicht 2 erreichen kann, wobei Strahlung 6, die seitlich auf den Sensor 1 auftritt, von dem ersten Schirm 7 blockiert wird.

Der Sensor 1 gemäß Fig. 3 weist einen zweiten Schirm 8 auf, der an der Trägerplatte 3 befestigt ist und undurchlässig für UV-Strahlung ist. Der zweite Schirm 8 stellt eine Blende dar, die das Sichtfeld des Sensors 1 einengt. Der zweite Schirm 8 ist derart geformt, dass er das photoelektrische Material in der Schicht 2 gegen eine senkrechte Einstrahlung abdeckt und eine seitliche Einstrahlung ermöglicht. Dazu kann der zweite Schirm 8 derart geformt sein, dass er eine sich senkrecht zu der Trägerplatte 3 erstreckende Öffnung aufweist. Die Sensoren 1 gemäß Figuren 1 bis 3 können eine zusätzliche Linse aufweisen. Es kann aber auch auf eine zusätzliche Linse verzichtet werden.

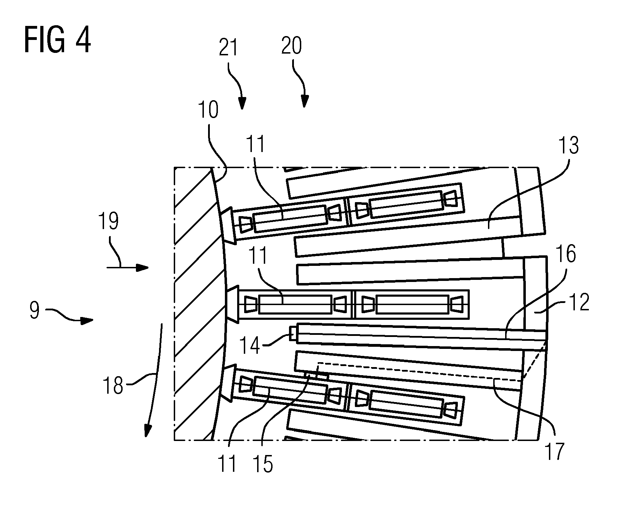

Figur 4 zeigt einen Querschnitt durch eine elektrische Maschine 9, die beispielsweise ein Elektromotor oder ein Generator sein kann. Die elektrische Maschine 9 weist einen Rotor (nicht in der Figur gezeigt) und einen Stator 21 auf, wobei der Stator 21 ein Blechpaket 10 aufweist. Das Blechpaket 10 weist Nuten auf, in die ein elektrischer Leiter 11 eingelegt ist. An der Stirnseite des Blechpakets 10 tritt der elektrische Leiter 11 aus dem Blechpaket 10 heraus und bildet dort einen Wickelkopf 20. Der elektrische Leiter 11 ist von einer Elektroisolation (nicht in Figur 4 dargestellt) umhüllt, um die elektrischen Leiter gegen das Blechpaket, gegen die Umgebung und gegen benachbarte Windungen der Wicklung elektrisch zu isolieren.

Die elektrische Maschine 9 weist eine Stützkonsole 12 auf, die beispielsweise an einem Gehäuse der elektrischen Maschine 9 angebracht sein kann und die eingerichtet ist, Schwingungen des Wickelkopfes 20 im Betrieb der elektrischen Maschine 9 zu dämpfen. Die Stützkonsole 12 weist eine Mehrzahl an Druckfingern 13 auf, die in Umfangsrichtung 18 der elektrischen Maschine 9 an den Windungen des Wickelkopfes 20 anliegen und dadurch eine Versteifung des Wickelkopfes 20 bewirken. Die elektrische Maschine 9 weist einen der Sensoren 1 gemäß eine der Figuren 1 bis 3 als einen Radialsensor 14 und eine der Sensoren 1 gemäß Figuren 1 bis 3 als einen Tangentialsensor 15 auf. Der Radialsensor 14 ist auf die schmale Seite eines der Druckfinger 13 aufgebracht und in der Radialrichtung 19 der elektrischen Maschine 9 gerichtet, so dass er in der Radialrichtung 19 nach außen emittierte UV Strahlung empfangen kann. Der Tangentialsensor 15 ist auf die lange Seite eines der Druckfinger 13 aufgebracht und ist in Umfangsrichtung 18 orientiert, so dass er in die Umfangsrichtung emittierte UV-Strahlung detektieren kann. An den Radialsensor 14 ist eine erste Messleitung 16 angebracht, die nach radial außen geführt ist. An den Tangentialsensor 15 ist eine zweite Messleitung 17 angebracht, die ebenfalls nach radial außen geführt ist. Die Messleitungen 16, 17 können dann nach außerhalb des Gehäuses des elektrischen Maschine 9 geführt werden.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektrische Maschine mit mindestens einem ein photoelektrisches Material aufweisenden Sensor (1),
der derart angeordnet ist, dass eine Elektroisolation der elektrischen Maschine (9) in dem Sichtfeld des Sensors (1) liegt, und
der derart eingerichtet ist, dass eine elektrische Größe des Sensors (1) auslesbar ist, und
einer Auswerteeinheit, die derart eingerichtet ist, dass sie die elektrische Größe auslesen kann und mit ihr aus der elektrischen Größe auf das Vorhandensein einer Teilentladung in der Elektroisolation rückschließbar ist.

2. Elektrische Maschine gemäß Anspruch 1,
wobei der Sensor (1) eine Blende aufweist, durch die das Sichtfeld auf den Sensor (1) abgebildet wird.

3. Elektrische Maschine gemäß Anspruch 2,
wobei der Sensor (1) eine Trägerplatte (3) aufweist, auf die das photoelektrische Material aufgebracht ist, und
die Blende einen lichtundurchlässigen Schirm (7, 8) aufweist, der an der Trägerplatte (3) fest angebracht ist.

4. Elektrische Maschine gemäß Anspruch 3,
wobei der Schirm (7) einen Ring aufweist, dessen eine Stirnseite an der Trägerplatte (3) fest angebracht ist und dessen Ringöffnung sich in Richtung von der Trägerplatte (3) weg verjüngt.

5. Elektrische Maschine gemäß Anspruch 3,
wobei der Schirm (8) derart geformt ist, dass er das photoelektrische Material gegen eine senkrechte Einstrahlung abdeckt und eine seitliche Einstrahlung ermöglicht.

6. Elektrische Maschine gemäß einem der Ansprüche 1 bis 5,
wobei eine Mehrzahl an den Sensoren (1) vorgesehen ist, die derart angeordnet sind, dass deren Sichtfelder teilweise überlappen, so dass aus den ausgegeben elektrischen Größen auf den Ort der Teilentladung zurückgeschlossen werden kann.

7. Elektrische Maschine gemäß einem der Ansprüche 1 bis 6,
wobei die elektrische Maschine einen Wickelkopf (20) aufweist und der mindestens eine Sensor (1) derart angeordnet ist, dass mit ihm auf das Vorhandensein von Teilentladungen im Bereich des Wickelkopfes (20) rückschließbar ist.

8. Elektrische Maschine gemäß Anspruch 7,
wobei die Elektroisolation elektrische Leiter (11) des Wickelkopfes (20) umhüllt und mindestens einer der Sensoren (1) auf die Außenseite der Elektroisolation des Wickelkopfes (20) aufgebracht ist.

9. Elektrische Maschine gemäß Anspruch 7 oder 8,
wobei die elektrische Maschine (9) eine Stützkonsole (12) aufweist, die den Wickelkopf (20) abstützt, und mindestens einer der Sensoren (1) an der Stützkonsole (12) angebracht ist.

10. Elektrische Maschine gemäß Anspruch 9,
wobei mindestens einer der Sensoren (1) eingerichtet ist Strahlung, die in Radialrichtung der elektrischen Maschine gerichtet ist, zu erfassen und mindestens einer der Sensoren (1) eingerichtet ist Strahlung, die in Umfangsrichtung der elektrischen Maschine gerichtet ist, zu erfassen.

11. Elektrische Maschine gemäß einem der Ansprüche 1 bis 10,
wobei das photoelektrische Material ein Metalloxid aufweist, das in einer Trägermatrix eingebettet ist.

12. Elektrische Maschine gemäß Anspruch 10 oder 11,
wobei die Trägermatrix ein Elastomer aufweist.

13. Verfahren zum Detektieren von Teilentladungen in einer Elektroisolation einer elektrischen Maschine (9) mit den Schritten:
- Anordnen mindestens eines Sensors (1) mit einem photoelektrischen Material an der elektrischen Maschine (9) derart, dass eine Elektroisolation der elektrischen Maschine (9) in dem Sichtfeld des Sensors (1) liegt;
- Messen einer elektrischen Größe des Sensors (1);
- Rückschließen aus der gemessenen elektrischen Größe auf das Vorhandensein einer Teilentladung in der Elektroisolation.

14. Verfahren gemäß Anspruch 13,
wobei eine Mehrzahl an den Sensoren (1) derart angeordnet wird, dass deren Sichtfelder teilweise überlappen, und wobei aus den gemessenen Größen auf den Ort der Teilentladung zurückgeschlossen wird.

15. Verfahren gemäß Anspruch 13 oder 14,
wobei zum Rückschließen auf das Vorhandensein einer Teilentladung ein Vergleich der elektrischen Größe im Betrieb der elektrischen Maschine und der elektrischen Größe im Stillstand der elektrischen Maschine durchgeführt wird.
